# EUROPEAN PATENT APPLICATION

(11) **EP 4 800 946 A1**
(43) Date of publication of application: **02.09.2026**
(21) Application number: 24890560.6
(22) Date of filing: 07.11.2024
(51) Int. Cl.: H04L 1/00

(54) **POLAR CODING METHOD AND APPARATUS**

(30) Priority: 16.11.2023 CN 202311535825
(71) Applicant: Huawei Technologies Co., Ltd., Shenzhen, Guangdong 518129 (CN)
(72) Inventor: WANG, Xianbin, Shenzhen, Guangdong 518129 (CN); ZHANG, Huazi, Shenzhen, Guangdong 518129 (CN); TONG, Jiajie, Shenzhen, Guangdong 518129 (CN); QIN, Kangjian, Shenzhen, Guangdong 518129 (CN); LIU, Ke, Shenzhen, Guangdong 518129 (CN); WANG, Jun, Shenzhen, Guangdong 518129 (CN)
(74) Representative: Pfenning, Meinig & Partner mbB
(86) International application number: PCT/CN2024/130502
(87) International publication number: WO 2025/103203

(57) **Abstract**

This application provides a polar code encoding method and an apparatus, to improve encoding performance. The method includes: determining, based on a length N of a first reliability sequence, a length M of a bit sequence to be transmitted, and a length K of an information bit corresponding to the bit sequence to be transmitted, a rate matching bit set and a threshold that correspond to the bit sequence to be transmitted, where M is a positive integer, N is a positive integer power of 2, and K is a positive integer less than M; determining the K information bits based on the first reliability sequence, the rate matching bit set, and the threshold; performing polar encoding based on the K information bits to obtain a polar encoding result; and performing rate matching based on the polar encoding result to obtain the bit sequence to be transmitted.

## Description

### TECHNICAL FIELD

This application relates to the communication field, and more specifically, to a polar code encoding method and an apparatus.

### BACKGROUND

Polar codes (polar codes) are a first channel coding scheme that has been rigorously proven to achieve the Shannon channel capacity, offering advantages of good decoding performance and low complexity. Currently, polar codes have been adopted by the 3rd generation partnership project (3rd generation partnership project, 3GPP) as a control channel coding scheme for uplink transmission and downlink transmission in 5G enhanced mobile broadband (enhanced mobile broadband, eMBB) scenarios.

In a polar code construction process, when a length of a polar code is different from a mother code length, it is necessary to determine a rate matching method, and determine positions of an information bit and a frozen bit based on the rate matching method and a reliability sequence. Over the past research, various rate matching schemes have been propose in both academia and industry. In a natural order (nature order, NAT)-based rate matching scheme, both shortened (shortened) bits and punctured (punctured) bits are consecutive, and implementation is simple. However, the rate matching scheme causes changes in a reliability order corresponding to a bit sequence. If a polar code is still constructed based on a pre-stored reliability sequence, decoding performance is poor in some cases, and bad positions are likely to occur.

### SUMMARY

This application provides a polar code encoding method and an apparatus, to improve encoding performance.

According to a first aspect, a polar code encoding method is provided. The method may be performed by a first communication device. Unless otherwise specified, the "first communication device" in this application may be the first communication device (for example, a network device or a terminal device), may be a component (for example, a processor, a chip, or a chip system) in the first communication device, or may be a logical module or software that can implement all or some functions of the first communication device. The method includes: determining, based on a length N of a first reliability sequence, a length M of a bit sequence to be transmitted, and a length K of an information bit corresponding to the bit sequence to be transmitted, a rate matching bit set and a threshold that correspond to the bit sequence to be transmitted, where M is a positive integer, N is a positive integer power of 2, and K is a positive integer less than M; determining the K information bits based on the first reliability sequence, the rate matching bit set, and the threshold; performing polar encoding based on the K information bits to obtain a polar encoding result; and performing rate matching based on the polar encoding result to obtain the bit sequence to be transmitted. The length of the bit sequence to be transmitted may be understood as a length after the rate matching.

Based on the foregoing technical solution, the K information bits corresponding to the bit sequence to be transmitted may be determined based on the determined threshold, the rate matching bit set, and the first reliability sequence. In this encoding process, the threshold is introduced to construct a polar code, so that a limitation on a rate matching manner can be reduced, implementation is simple, and a bad point can be avoided. Therefore, encoding performance can be improved.

With reference to the first aspect, in some implementations of the first aspect, determining, based on the length N of the first reliability sequence, the length M of the bit sequence to be transmitted, and the length K of the information bit corresponding to the bit sequence to be transmitted, the rate matching bit set and the threshold that correspond to the bit sequence to be transmitted includes: determining, based on the length M of the bit sequence to be transmitted and the length K of the information bit, a rate matching manner corresponding to the bit sequence to be transmitted; determining the rate matching bit set based on the rate matching manner, the length N of the first reliability sequence, and the length M of the bit sequence to be transmitted; and determining the threshold based on the rate matching manner, the length N of the first reliability sequence, the length M of the bit sequence to be transmitted, and the length K of the information bit. In this optional solution, accuracy of the determined information bit corresponding to the bit sequence to be transmitted can be improved, and therefore polar code encoding performance is improved.

With reference to the first aspect, in some implementations of the first aspect, if M/N is greater than or equal to a first preset threshold value, or K/M is greater than a second preset threshold value, the threshold is a first value, where the first value is associated with the length N of the first reliability sequence; if K/M is greater than a third preset threshold value and is less than or equal to the second preset threshold value, the threshold is a second value, where the second value is associated with the length N of the first reliability sequence; if K/M is less than or equal to the third preset threshold value, the threshold is a third value, where the third value is associated with the length N of the first reliability sequence, and the rate matching manner corresponding to the bit sequence to be transmitted is shortening. This implementation is an example of determining the threshold when the rate matching manner is shortening.

With reference to the first aspect, in some implementations of the first aspect, determining the threshold based on the length N of the first reliability sequence, the length M of the bit sequence to be transmitted, and the length K of the information bit corresponding to the bit sequence to be transmitted includes: determining a parameter set based on the length N of the first reliability sequence and the length K of the information bit; and determining the threshold based on the parameter set, the length N of the first reliability sequence, and the length M of the bit sequence to be transmitted, where the rate matching manner corresponding to the bit sequence to be transmitted is puncturing. This implementation is an example of determining the threshold when the rate matching manner is puncturing.

With reference to the first aspect, in some implementations of the first aspect, if M/N is greater than or equal to a first parameter, and the first parameter is a parameter with a largest value among parameters included in the parameter set, the threshold is a fourth value, where the fourth value is associated with the length N of the first reliability sequence; if M/N is less than the first parameter and is greater than or equal to a second parameter, and a value of the second parameter is less than a value of the first parameter, the threshold is a fifth value, where the fifth value is associated with the length N of the first reliability sequence, and the parameter set includes the second parameter; if M/N is less than an (S-1)^{th} parameter and is greater than or equal to an S^{th} parameter, the S^{th} parameter is a parameter with a smallest value among the parameters included in the parameter set, and a value of the S^{th} parameter is less than a value of the (S-1)^{th} parameter, the threshold is an (S+3)^{th} value, where the (S+3)^{th} value is associated with the length N of the first reliability sequence, and S is a positive integer; if M/N is less than the S^{th} parameter, the threshold is an (S+4)^{th} value, where the (S+4)^{th} value is associated with the length N of the first reliability sequence.

With reference to the first aspect, in some implementations of the first aspect, if M/N is greater than a first parameter, and the first parameter is a parameter with a largest value among parameters included in the parameter set, the threshold is a fourth value, where the fourth value is associated with the length N of the first reliability sequence; if M/N is less than or equal to the first parameter and is greater than a second parameter, and a value of the second parameter is less than a value of the first parameter, the threshold is a fifth value, where the fifth value is associated with the length N of the first reliability sequence, and the parameter set includes the second parameter; if M/N is less than or equal to an (S-1)^{th} parameter and is greater than an S^{th} parameter, the S^{th} parameter is a parameter with a smallest value among the parameters included in the parameter set, and a value of the S^{th} parameter is less than a value of the (S-1)^{th} parameter, the threshold is an (S+3)^{th} value, where the (S+3)^{th} value is associated with the length N of the first reliability sequence, and S is a positive integer; if M/N is less than or equal to the S^{th} parameter, the threshold is an (S+4)^{th} value, where the (S+4)^{th} value is associated with the length N of the first reliability sequence.

With reference to the first aspect, in some implementations of the first aspect, determining, based on the first reliability sequence, the rate matching bit set, and the threshold, the K information bits corresponding to the bit sequence to be transmitted includes: removing a bit included in the rate matching bit set from the first reliability sequence, to obtain a second reliability sequence, where a length of the second reliability sequence is less than or equal to M; determining a first subsequence and a second subsequence based on the second reliability sequence; and determining the K information bits based on the second reliability sequence, the first subsequence, the second subsequence, and the threshold.

With reference to the first aspect, in some implementations of the first aspect, removing the bit included in the rate matching bit set from the first reliability sequence, to obtain the second reliability sequence includes: removing sequence numbers corresponding to the rate matching bit set and a pre-frozen bit set from the first reliability sequence, to obtain the second reliability sequence, where the pre-frozen bit set is determined based on the length M of the bit sequence to be transmitted and the length N of the first reliability sequence. In this optional solution, the second reliability sequence is obtained by removing the sequence numbers corresponding to the rate matching bit set and the pre-frozen bit set from the first reliability sequence, so that accuracy of determining the information bit can be improved, and therefore transmission performance of polar code encoding is improved.

With reference to the first aspect, in some implementations of the first aspect, the method further includes: determining the pre-frozen bit set based on the length M of the bit sequence to be transmitted and the length N of the first reliability sequence.

With reference to the first aspect, in some implementations of the first aspect, determining the pre-frozen bit set based on the length M of the bit sequence to be transmitted and the length N of the first reliability sequence includes: determining bits corresponding to first ceil((N-M)/Δ)*Δ subchannels of the polar encoding as the pre-frozen bit set; or determining bits corresponding to first max(L, ceil((N-M)/Δ)*Δ) subchannels of the polar encoding as the pre-frozen bit set, where ceil() represents rounding up, and Δ and L are associated with the length N of the first reliability sequence.

With reference to the first aspect, in some implementations of the first aspect, a sequence number of a bit included in the first subsequence is less than N/2, and a sequence number of a bit included in the second subsequence is greater than or equal to N/2, where a smallest sequence number in the first reliability sequence is 0. Optionally, the sequence number of the bit included in the first subsequence is less than or equal to N/2, and the sequence number of the bit included in the second subsequence is greater than N/2, where the smallest sequence number in the first reliability sequence is 1.

With reference to the first aspect, in some implementations of the first aspect, a reliability sequence corresponding to a sequence number greater than or equal to N/2 in the second reliability sequence is used as the second subsequence, and the first subsequence is determined based on the second subsequence. For example, N=8, the first reliability sequence S1 is [0 1 2 4 3 5 6 7], M=6, the rate matching manner is puncturing, and the second reliability sequence is [2 4 3 5 6 7]. In this case, the second subsequence is [4 5 6 7]. A 3^{rd} sequence number and a 4^{th} sequence number that correspond to the second subsequence may be extracted as the first subsequence, so that the first subsequence is [6 7]. Alternatively, a 1^{st} sequence number and a 2^{nd} sequence number that correspond to the second subsequence may be extracted as the first subsequence, so that the first subsequence is [4 5]. For another example, N=8, the first reliability sequence S1 is [0 1 2 4 3 5 6 7], M=8, and the second reliability sequence is [0 1 2 4 3 5 6 7]. In this case, the second subsequence is [4 5 6 7]. [0 1 2 3] is obtained by subtracting N/2 from each element in the second subsequence and used as the first subsequence. Alternatively, the second subsequence may be directly used as the first subsequence.

With reference to the first aspect, in some implementations of the first aspect, a reliability sequence corresponding to a sequence number less than N/2 in the second reliability sequence is used as the first subsequence, and the second subsequence is determined based on the first subsequence. For example, N=8, the first reliability sequence S1 is [0 1 2 4 3 5 6 7], M=6, the rate matching manner is shortening, and the second reliability sequence is [0 1 2 4 3 5]. In this case, the first subsequence is [0 1 2 3]. A 1^{st} sequence number and a 2^{nd} sequence number that correspond to the first subsequence may be extracted as the second subsequence, so that the second subsequence is [0 1]. Alternatively, a 3^{rd} sequence number and a 4^{th} sequence number that correspond to the first subsequence may be extracted as the second subsequence, so that the second subsequence is [2 3]. For another example, N=8, the first reliability sequence S1 is [0 1 2 4 3 5 6 7], M=8, and the second reliability sequence is [0 1 2 4 3 5 6 7]. In this case, the first subsequence is [0 1 2 3]. [4 5 6 7] is obtained by adding N/2 to each element in the first subsequence and used as the second subsequence. Alternatively, the first subsequence may be directly used as the second subsequence.

With reference to the first aspect, in some implementations of the first aspect, determining the K information bits based on the second reliability sequence, the first subsequence, the second subsequence, and the threshold includes: if an i^{th} last sequence number in the second reliability sequence is greater than or equal to the threshold, determining that a bit indicated by a j^{th} last sequence number in the second subsequence is the information bit, where i is a positive integer ranging from 1 to K, and j is a positive integer ranging from 1 to K; if an i^{th} last sequence number in the second reliability sequence is less than the threshold, determining that a bit indicated by a q^{th} last sequence number in the first subsequence is the information bit, where q is a positive integer ranging from 1 to K.

With reference to the first aspect, in some implementations of the first aspect, determining the K information bits based on the second reliability sequence, the first subsequence, the second subsequence, and the threshold includes: if a last sequence number in the second reliability sequence is greater than or equal to the threshold, determining that a bit indicated by a last sequence number in the second subsequence is a 1^{st} information bit; if a 2^{nd} last sequence number in the second reliability sequence is greater than or equal to the threshold, determining that a bit indicated by a 2^{nd} last sequence number in the second subsequence is a 2^{nd} information bit; if a 2^{nd} last sequence number in the second reliability sequence is less than the threshold, determining that a bit indicated by a last sequence number in the first subsequence is a 2^{nd} information bit.

With reference to the first aspect, in some implementations of the first aspect, determining the K information bits based on the second reliability sequence, the first subsequence, the second subsequence, and the threshold includes: if the last sequence number in the second reliability sequence is less than the threshold, determining that the bit indicated by the last sequence number in the first subsequence is the 1^{st} information bit; if the 2^{nd} last sequence number in the second reliability sequence is greater than or equal to the threshold, determining that the bit indicated by the last sequence number in the second subsequence is the 2^{nd} information bit; if the 2^{nd} last sequence number in the second reliability sequence is less than the threshold, determining that a bit indicated by a 2^{nd} last sequence number in the first subsequence is the 2^{nd} information bit.

With reference to the first aspect, in some implementations of the first aspect, the rate matching manner corresponding to the bit sequence to be transmitted includes puncturing or shortening.

With reference to the first aspect, in some implementations of the first aspect, when the rate matching manner corresponding to the bit sequence to be transmitted is puncturing, the rate matching bit set includes first N-M bits in the first reliability sequence; and when the rate matching manner corresponding to the bit sequence to be transmitted is shortening, the rate matching bit set includes last N-M bits in the first reliability sequence.

According to a second aspect, a communication apparatus is provided. The apparatus may be a first communication device (for example, a network device or a terminal device), may be a component (for example, a processor, a chip, or a chip system) in the first communication device, or may be a logical module or software that can implement all or some functions of the first communication device. The apparatus includes: a processing module, configured to determine, based on a length N of a first reliability sequence, a length M of a bit sequence to be transmitted, and a length K of an information bit corresponding to the bit sequence to be transmitted, a rate matching bit set and a threshold that correspond to the bit sequence to be transmitted, where M is a positive integer, N is a positive integer power of 2, and K is a positive integer less than M, where the processing module is further configured to determine the K information bits based on the first reliability sequence, the rate matching bit set, and the threshold; and an encoding module, configured to perform polar encoding based on the K information bits to obtain a polar encoding result, where the encoding module is further configured to perform rate matching based on the polar encoding result to obtain the bit sequence to be transmitted.

With reference to the second aspect, in some implementations of the second aspect, the processing module is specifically configured to: determine, based on the length M of the bit sequence to be transmitted and the length K of the information bit, a rate matching manner corresponding to the bit sequence to be transmitted; determine the rate matching bit set based on the rate matching manner, the length N of the first reliability sequence, and the length M of the bit sequence to be transmitted; and determine the threshold based on the rate matching manner, the length N of the first reliability sequence, the length M of the bit sequence to be transmitted, and the length K of the information bit.

With reference to the second aspect, in some implementations of the second aspect, if M/N is greater than or equal to a first preset threshold value, or K/M is greater than a second preset threshold value, the threshold is a first value, where the first value is associated with the length N of the first reliability sequence; if K/M is greater than a third preset threshold value and is less than or equal to the second preset threshold value, the threshold is a second value, where the second value is associated with the length N of the first reliability sequence; if K/M is less than or equal to the third preset threshold value, the threshold is a third value, where the third value is associated with the length N of the first reliability sequence, and the rate matching manner corresponding to the bit sequence to be transmitted is shortening.

With reference to the second aspect, in some implementations of the second aspect, the processing module is specifically configured to: determine a parameter set based on the length N of the first reliability sequence and the length K of the information bit; and determine the threshold based on the parameter set, the length N of the first reliability sequence, and the length M of the bit sequence to be transmitted, where the rate matching manner corresponding to the bit sequence to be transmitted is puncturing.

With reference to the second aspect, in some implementations of the second aspect, if M/N is greater than or equal to a first parameter, and the first parameter is a parameter with a largest value among parameters included in the parameter set, the threshold is a fourth value, where the fourth value is associated with the length N of the first reliability sequence; if M/N is less than the first parameter and is greater than or equal to a second parameter, and a value of the second parameter is less than a value of the first parameter, the threshold is a fifth value, where the fifth value is associated with the length N of the first reliability sequence, and the parameter set includes the second parameter; if M/N is less than an (S-1)^{th} parameter and is greater than or equal to an S^{th} parameter, the S^{th} parameter is a parameter with a smallest value among the parameters included in the parameter set, and a value of the S^{th} parameter is less than a value of the (S-1)^{th} parameter, the threshold is an (S+3)^{th} value, where the (S+3)^{th} value is associated with the length N of the first reliability sequence, and S is a positive integer; if M/N is less than the S^{th} parameter, the threshold is an (S+4)^{th} value, where the (S+4)^{th} value is associated with the length N of the first reliability sequence.

With reference to the second aspect, in some implementations of the second aspect, the processing module is specifically configured to: remove a bit included in the rate matching bit set from the first reliability sequence, to obtain a second reliability sequence, where a length of the second reliability sequence is less than or equal to M; determine a first subsequence and a second subsequence based on the second reliability sequence; and determine the K information bits based on the second reliability sequence, the first subsequence, the second subsequence, and the threshold.

With reference to the second aspect, in some implementations of the second aspect, the processing module is specifically configured to: remove sequence numbers corresponding to the rate matching bit set and a pre-frozen bit set from the first reliability sequence, to obtain the second reliability sequence, where the pre-frozen bit set is determined based on the length M of the bit sequence to be transmitted and the length N of the first reliability sequence.

With reference to the second aspect, in some implementations of the second aspect, the processing module is further configured to determine the pre-frozen bit set based on the length M of the bit sequence to be transmitted and the length N of the first reliability sequence.

With reference to the second aspect, in some implementations of the second aspect, the processing module is specifically configured to: determine bits corresponding to first ceil((N-M)/Δ)*Δ subchannels of the polar encoding as the pre-frozen bit set; or determine bits corresponding to first max(L, ceil((N-M)/Δ)*Δ) subchannels of the polar encoding as the pre-frozen bit set, where ceil() represents rounding up, and Δ and L are associated with the length N of the first reliability sequence.

With reference to the second aspect, in some implementations of the second aspect, a sequence number of a bit included in the first subsequence is less than N/2, and a sequence number of a bit included in the second subsequence is greater than or equal to N/2.

With reference to the second aspect, in some implementations of the second aspect, the processing module is specifically configured to: if an i^{th} last sequence number in the second reliability sequence is greater than or equal to the threshold, determine that a bit indicated by a j^{th} last sequence number in the second subsequence is the information bit, where i is a positive integer ranging from 1 to K, and j is a positive integer ranging from 1 to K; if an i^{th} last sequence number in the second reliability sequence is less than the threshold, determine that a bit indicated by a q^{th} last sequence number in the first subsequence is the information bit, where q is a positive integer ranging from 1 to K.

With reference to the second aspect, in some implementations of the second aspect, the processing module is specifically configured to: if a last sequence number in the second reliability sequence is greater than or equal to the threshold, determine that a bit indicated by a last sequence number in the second subsequence is a 1^{st} information bit; if a 2^{nd} last sequence number in the second reliability sequence is greater than or equal to the threshold, determine that a bit indicated by a 2^{nd} last sequence number in the second subsequence is a 2^{nd} information bit; if a 2^{nd} last sequence number in the second reliability sequence is less than the threshold, determine that a bit indicated by a last sequence number in the first subsequence is a 2^{nd} information bit.

With reference to the second aspect, in some implementations of the second aspect, the processing module is specifically configured to: if the last sequence number in the second reliability sequence is less than the threshold, determine that the bit indicated by the last sequence number in the first subsequence is the 1^{st} information bit; if the 2^{nd} last sequence number in the second reliability sequence is greater than or equal to the threshold, determine that the bit indicated by the last sequence number in the second subsequence is the 2^{nd} information bit; if the 2^{nd} last sequence number in the second reliability sequence is less than the threshold, determine that a bit indicated by a 2^{nd} last sequence number in the first subsequence is the 2^{nd} information bit.

With reference to the second aspect, in some implementations of the second aspect, the rate matching manner corresponding to the bit sequence to be transmitted includes puncturing or shortening.

With reference to the second aspect, in some implementations of the second aspect, when the rate matching manner corresponding to the bit sequence to be transmitted is puncturing, the rate matching bit set includes first N-M bits in the first reliability sequence; and when the rate matching manner corresponding to the bit sequence to be transmitted is shortening, the rate matching bit set includes last N-M bits in the first reliability sequence.

According to a third aspect, a communication apparatus is provided. The communication apparatus includes a processor and a memory. The memory is configured to store a computer program. The processor is configured to execute a part or all of the computer program stored in the memory, to perform the method according to any one of the first aspect and the possible implementations of the first aspect.

According to a fourth aspect, a communication apparatus is provided. The communication apparatus includes an input/output interface and a logic circuit. The input/output interface is configured to obtain input information and/or output information. The logic circuit is configured to: perform the method according to any one of the first aspect and the possible implementations of the first aspect, and perform processing and/or generate the output information based on the input information.

According to a fifth aspect, a computer-readable storage medium is provided. The computer-readable medium stores a computer program. When the computer program is run on a computer, the method according to any one of the first aspect and the possible implementations of the first aspect is performed.

According to a sixth aspect, a computer program product including instructions is provided. When the instructions are executed by a computer, a communication apparatus is enabled to implement the method according to any one of the first aspect and the possible implementations of the first aspect.

The solutions provided in the second aspect to the sixth aspect are used to implement or cooperatively implement the method provided in the first aspect, and therefore can achieve beneficial effect the same as or corresponding to that of the first aspect. Details are not described herein again.

### BRIEF DESCRIPTION OF DRAWINGS

FIG. 1 is a diagram of a communication procedure of a communication system;
FIG. 2 is a diagram of a network architecture to which embodiments of this application are applicable;
FIG. 3 is a diagram of encoding of a polar code with a length of 8;
FIG. 4 is a diagram of performance comparison between polar codes constructed based on a new radio (new radio, NR) sequence and polar codes constructed based on Gaussian approximation (Gaussian approximation, GA) during natural-order rate matching;
FIG. 5 is a schematic flowchart of a polar code encoding method according to an embodiment of this application;
FIG. 6 is a block diagram of a communication apparatus according to an embodiment of this application; and
FIG. 7 is a block diagram of another communication apparatus according to an embodiment of this application.

### DESCRIPTION OF EMBODIMENTS

The following describes technical solutions of this application with reference to accompanying drawings.

Embodiments of this application may be applied to various communication systems, for example, a wireless local area network (wireless local area network, WLAN) system, an internet of things (internet of things, IoT) system, a long term evolution (long term evolution, LTE) system, satellite communication, a sidelink (sidelink, SL), a 4th generation (4th generation, 4G) communication system, a 5th generation (5th generation, 5G) communication system, or a new communication system that appears in the future. The communication system includes communication devices, and wireless communication may be performed between the communication devices on an air interface resource. The communication devices may include a network device and a terminal device, and the network device may also be referred to as a base station device.

The terminal device in embodiments of this application may include various handheld devices, vehicle-mounted devices, wearable devices, or computing devices that have a wireless communication function, or other processing devices connected to a wireless modem. The terminal may be a subscriber unit (subscriber unit), user equipment (user equipment, UE), a cellular phone (cellular phone), a smartphone (smartphone), a wireless data card, a personal digital assistant (personal digital assistant, PDA) computer, a tablet computer, a wireless modulator-demodulator (modulator-demodulator, modem), a laptop computer (laptop computer), a machine type communication (machine type communication, MTC) terminal, a wireless terminal in self-driving (self-driving), or the like. The user equipment includes vehicle user equipment. With emergence of internet of things (internet of things, IoT) technologies, more devices that previously do not have a communication function, for example, but not limited to, a household appliance, a transportation vehicle, a tool device, a service device, and a service facility, start to obtain a wireless communication function by being configured with a wireless communication unit, so that the devices can access a wireless communication network and be remotely controlled. Such a device has the wireless communication function because the device is configured with the wireless communication unit, and is therefore classified as a wireless communication device. In addition, the terminal device may also be referred to as a mobile station (mobile station, MS), a mobile device, a mobile terminal, a wireless terminal, a handset (handset), a client, a virtual reality (virtual reality, VR) terminal device, an augmented reality (augmented reality, AR) terminal device, a wireless terminal in industrial control, a wireless terminal in self-driving, a wireless terminal in telemedicine, a wireless terminal in a smart grid, a wireless terminal in a smart city (smart city), a wireless terminal in a smart home (smart home), or the like.

In embodiments of this application, an apparatus configured to implement a function of the technical solution may be a terminal device, or may be a chip system that can support the terminal device in implementing the function. The apparatus, for example, a system on chip (system on chip, SoC) or a modem (modem), may be installed in the terminal device. In embodiments of this application, the chip system may include a chip, or may include a chip and another discrete component. In this application, the technical solutions provided in embodiments of this application are described by using an example in which the terminal device is user equipment UE.

For example, the network device may be an access network device, an evolved NodeB (evolved NodeB, eNB), a radio network controller (radio network controller, RNC), a NodeB (NodeB, NB), a base station controller (base station controller, BSC), a base transceiver station (base transceiver station, BTS), a home base station (home evolved NodeB, or home NodeB, HNB), a baseband unit (baseband unit, BBU), a device that bears a base station function in device to device (device to device, D2D), an access point (access point, AP) in a wireless fidelity (wireless fidelity, Wi-Fi) system, a wireless relay node, a wireless backhaul node, a transmission point (transmission point, TP), a transmission reception point (transmission reception point, TRP), or the like; or may be a gNB or a transmission point (for example, a TRP or a TP) in NR, or one antenna panel or a group of antenna panels (including a plurality of antenna panels) of a base station in NR; or may be a network node, for example, a baseband unit (baseband unit, BBU) or a distributed unit (distributed unit, DU), that forms a gNB or a transmission point. Alternatively, the network device may be a vehicle-mounted device, a wearable device, a network device in a 6G network, a network device in a future evolved PLMN, a network device deployed on a satellite, or the like. This is not limited. In addition, based on sizes of provided service coverage areas, base stations (base stations, BSs) may be classified into macro base stations for providing a macro cell (macro cell), micro base stations for providing a micro cell (pico cell), and femto base stations for providing a femto cell (femto cell), relay stations, access points, and the like. With continuous evolution of wireless communication technologies, a future base station may alternatively use another name.

The network device has abundant product forms. For example, in a product implementation process, a BBU and a radio frequency unit (radio frequency unit, RFU) may be integrated into a same device, and the device is connected to an antenna array through a cable (for example, but not limited to, a feeder). The BBU and the RFU may alternatively be disposed separately, are connected to each other through an optical fiber, and communicate with each other through, for example, but not limited to, a common public radio interface (common public radio interface, CPRI) protocol. In this case, the RFU is usually referred to as a remote radio unit (remote radio unit, RRU), and is connected to the antenna array through the cable. In addition, the RRU may alternatively be integrated with the antenna array. For example, currently, this structure is used for an active antenna unit (active antenna unit, AAU) product in the market.

In addition, the BBU may be further decomposed into a plurality of parts. For example, the BBU may be further divided into a central unit (central unit, CU) and a distributed unit (distributed unit, DU) based on a real-time requirement of a processed service. The CU is responsible for processing a non-real-time protocol and service, and the DU is responsible for processing a physical layer protocol and a real-time service. Further, some physical layer functions may be separated from the BBU or the DU and integrated into an AAU.

Similar to an implementation form of the terminal device, an apparatus configured to implement a function of the technical solution may be a network device, or may be a chip system that can support the network device in implementing the function. The apparatus, for example, a system on chip SoC or a modem (modem), may be installed in the network device. In embodiments of this application, the chip system may include a chip, or may include a chip and another discrete component.

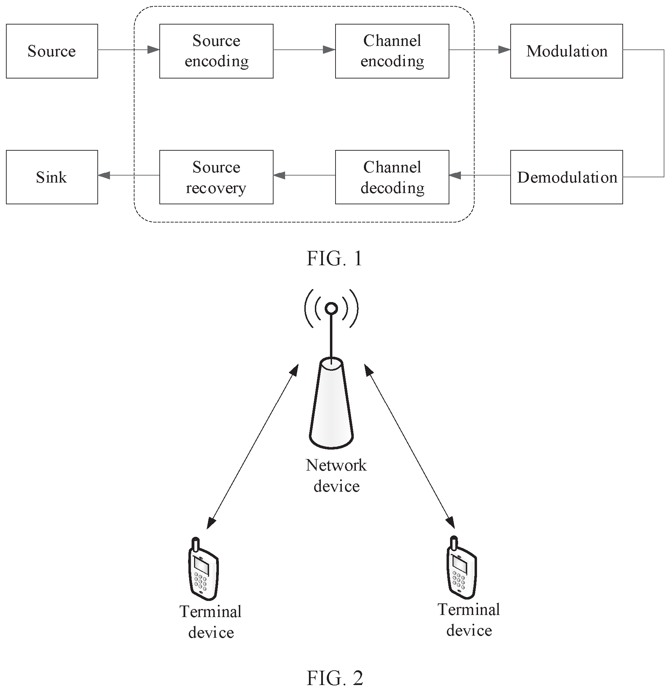

Embodiments of this application may be implemented by using an application-specific integrated circuit (application-specific integrated circuit, ASIC) or a field programmable gate array (field programmable gate array, FPGA), or may be implemented by using program code in software/a memory. In a communication procedure of a communication system, embodiments of this application mainly relate to source encoding, channel encoding, channel decoding, and source recovery. FIG. 1 is a diagram of a communication procedure of a communication system.

FIG. 2 is a diagram of a network architecture to which embodiments of this application are applicable. The network architecture includes a network device and terminal devices. The network device may transmit data or control information to the terminal device, and the terminal device may also transmit data or control information to the network device. The network device in embodiments of this application may be a base station.

For ease of understanding of embodiments of this application, the following briefly describes polar code-related technical solutions.

Polar codes are a first channel coding scheme that has been rigorously proven to achieve the Shannon channel capacity, offering advantages of good decoding performance and low complexity. Currently, the polar codes have been adopted by the 3GPP as a control channel coding scheme for uplink transmission and downlink transmission in a 5G eMBB scenario.

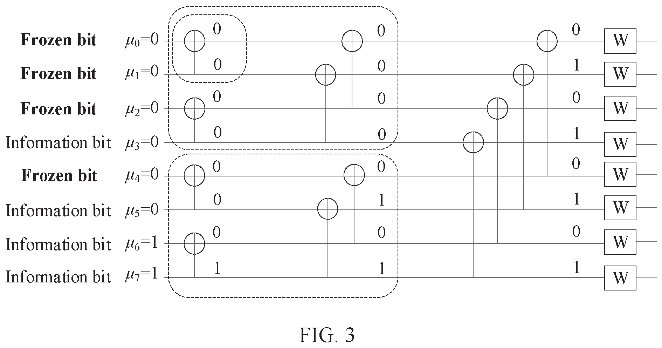

FIG. 3 is a diagram of encoding of a polar code with a length of 8. An encoding process includes several polarization kernel operations, and each polarization kernel multiplies two input bits by $\left[\begin{matrix}1 & 0 \\ 1 & 1\end{matrix}\right]$, to obtain two output bits. It can be learned that the polar code is a code constructed based on recursion. The polar code with the length of 8 may be considered as being obtained by coupling two polar codes with a length of 4 by using four polarization kernels with a length of 2, and each polar code with a length of 4 may be considered as being obtained by coupling two polar codes with a length of 2 by using two polarization kernels with a length of 2. A polar code with a code length of an integer power of 2, for example, a polar code with a code length of 4, 8, 16, 32, or 64 is usually referred to as a polar code with a mother code length.

In a polar code construction process, two objectives need to be completed: First, when a polar code is of a non-mother code length, a rate matching method is determined. Second, positions of an information bit and a frozen bit are determined based on the rate matching method and a reliability sequence.

### 1. Rate matching method

During actual application, a length M of a required polar code is not necessarily an integer power of 2, and the polar code is usually referred to as a polar code of a non-mother code length. In this case, some bits need to be removed from a mother code and are not sent, or some bits are repeated and then sent. This process is usually referred to as rate matching (rate matching). The rate matching method includes:
(1) Puncturing (puncturing): "Puncturing" means that some positions of a polar code of a mother code length are directly removed and are not sent. According to this method, an encoded bit sequence of a polar code with any length is generated. On a decoding side, because the corresponding "punctured" position carries no information, a log-likelihood ratio (log-likelihood ratio, LLR) of a bit at the corresponding position is set to 0.
(2) Shortening (shortening): "Shortening" is another common rate matching method. According to this method, a polar code is designed, so that some positions in an encoded bit sequence have fixed values, and the fixed values do not need to be sent. On a decoding side, because a receive end has known the fixed value at the "shortened" position, where the value is usually 0, an LLR of a bit at the corresponding position is set to infinity.
(3) Repetition (repetition): "Repetition" means that some positions of a polar code are repeated and then sent. According to this method, an encoded bit sequence of a polar code with any length is generated.

### 2. Position determining of an information bit and a frozen bit

A bit with high reliability is set as an information bit (data), and a bit with low reliability is set as a frozen (frozen) bit. A value of the frozen bit is usually set to 0, which is known to both a transmit end and a receive end during actual transmission. In 5G NR, positions of a frozen bit and an information bit in a polar code are determined based on a reliability sequence. For example, when a bit sequence occupies eight bits, and the eight bits are respectively represented as *µ*₀, *µ*₁, *µ*₂, *µ*₃, *µ*₄, *µ*₅, *µ*₆, and *µ*₇ from left to right, if a reliability sequence ordered from low reliability to high reliability is [0, 1, 2, 4, 3, 5, 6, 7], *µ*₇ has the highest reliability, and *µ*₆ has the second highest reliability. When a polar code with a code length of 8 and four information bits is constructed, *µ*₇, *µ*₆, *µ*₅, and *µ*₃ are selected from back to front based on the reliability sequence as information bits, and *µ*₄, *µ*₂, *µ*₁, and *µ*₀ are frozen bits. The frozen bit may be referred to as a fixed bit.

Because a rate matching process affects reliability ordering of a polar code, rate matching affects position determining of an information bit and a frozen bit. The two processes are strongly coupled.

### 3. Natural order-based rate matching scheme

The natural order-based rate matching scheme means that puncturing or shortening is consecutively performed on a bit sequence corresponding to a polar code in a natural order. Puncturing is used as an example. When a polar code with a length of 6 needs to be constructed, a polar code with a length of 8 is first constructed, and then first two bits are punctured. When a polar code with a length of 5 needs to be constructed, a polar code with a length of 8 is first constructed, and then first three bits are punctured. In a case in which a rate matching method of shortening is used, when a polar code with a length of 7 needs to be constructed, a polar code with a length of 8 is first constructed, and then µ₇ is preset to 0, so that x₇ in an encoded bit sequence is 0, where x₇ is obtained by performing polar encoding on µ₇; and when a polar code with a length of 6 needs to be constructed, a polar code with a length of 8 is first constructed, and then µ₆ and µ₇ are preset to 0, so that x₆ and x₇ in an encoded bit sequence are 0, where x₆ is obtained by performing polar encoding on µ₆, and x₇ is obtained by performing polar encoding on µ₇.

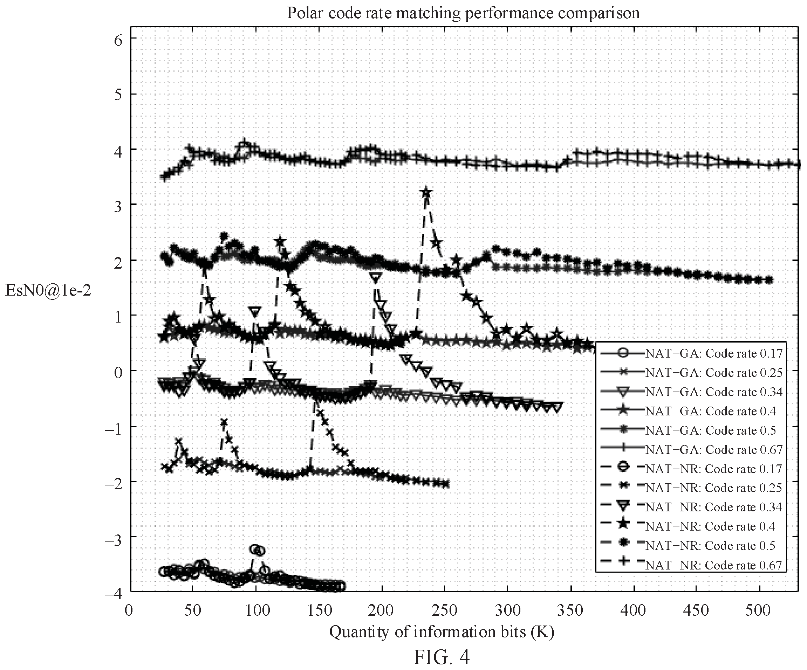

In the natural order-based rate matching scheme, both shortened bits and punctured bits are consecutive, and implementation is simple. However, the natural order-based rate matching scheme causes a change in a reliability order corresponding to the bit sequence. If the polar code is still constructed based on a pre-stored reliability sequence, decoding performance is poor in some cases, and a bad point is easily formed. The "bad point" may be understood as a point at which a signal-to-noise ratio (signal-to-noise ratio, SNR) required for achieving same transmission performance suddenly increases. FIG. 4 is a diagram of performance comparison between polar codes constructed based on an NR sequence and polar codes constructed based on Gaussian approximation during natural-order rate matching. A horizontal coordinate represents a length K of an information bit, and a vertical coordinate represents a signal-to-noise ratio SNR required for achieving a packet error rate of 1e-2.

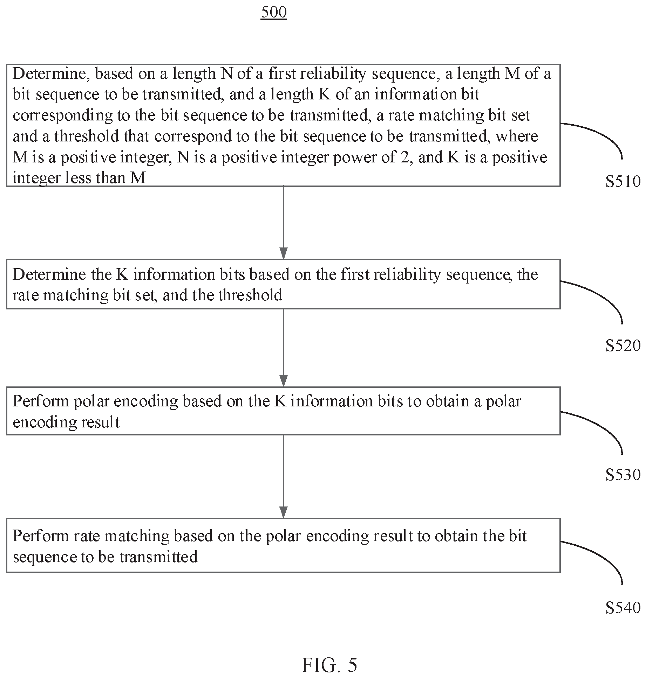

Embodiments of this application provide a polar code encoding method. The polar code encoding method can avoid a bad point. In this way, encoding performance can be improved. FIG. 5 is a schematic flowchart of a polar code encoding method 500 according to an embodiment of this application. The polar code encoding method provided in this embodiment of this application may be executed by a first communication device. The "first communication device" in this application may be the first communication device (for example, a network device or a terminal device), may be a component (for example, a processor, a chip, or a chip system) in the first communication device, or may be a logical module or software that can implement all or some functions of the first communication device.

S510: Determine, based on a length N of a first reliability sequence, a length M of a bit sequence to be transmitted, and a length K of an information bit corresponding to the bit sequence to be transmitted, a rate matching bit set and a threshold that correspond to the bit sequence to be transmitted, where M is a positive integer, N is a positive integer power of 2, and K is a positive integer less than M. The rate matching bit set and the threshold are used to determine K information bits corresponding to the bit sequence to be transmitted. N is a mother code length, and M is a length after rate matching.

Optionally, a rate matching manner corresponding to the bit sequence to be transmitted is determined based on the length M of the bit sequence to be transmitted and the length K of the information bit; and the rate matching bit set corresponding to the bit sequence to be transmitted is determined based on the rate matching manner, the length N of the first reliability sequence, and the length M of the bit sequence to be transmitted. For example, the rate matching manner includes puncturing, shortening, or repetition. If M<N and K/M≤7/16, the rate matching manner corresponding to the bit sequence to be transmitted is puncturing. If M<N and K/M>7/16, the rate matching manner corresponding to the bit sequence to be transmitted is shortening. If M>N, the rate matching manner corresponding to the bit sequence to be transmitted is repetition.

For example, when the rate matching manner corresponding to the bit sequence to be transmitted is puncturing, the rate matching bit set includes first N-M bits in the first reliability sequence; or when the rate matching manner corresponding to the bit sequence to be transmitted is shortening, the rate matching bit set includes last N-M bits in the first reliability sequence. In this embodiment of this application, a transmit end (the terminal device or the network device) may still use a rate matching manner of sequential puncturing or sequential shortening, which is easy to implement and can avoid a bad point, so that encoding performance can be improved.

Optionally, the rate matching manner corresponding to the bit sequence to be transmitted is determined based on the length M of the bit sequence to be transmitted and the length K of the information bit; and the threshold is determined based on the rate matching manner, the length N of the first reliability sequence, the length M of the bit sequence to be transmitted, and the length K of the information bit. In this optional solution, accuracy of the determined information bit corresponding to the bit sequence to be transmitted can be improved, and therefore polar code encoding performance is improved.

For example, when the rate matching manner corresponding to the bit sequence to be transmitted is shortening, if M/N is greater than or equal to a first preset threshold value, or K/M is greater than a second preset threshold value, the threshold is a first value, where the first value is associated with the length N of the first reliability sequence; if K/M is greater than a third preset threshold value and is less than or equal to the second preset threshold value, the threshold is a second value, where the second value is associated with the length N of the first reliability sequence; if K/M is less than or equal to the third preset threshold value, the threshold is a third value, where the third value is associated with the length N of the first reliability sequence. The first preset threshold value, the second preset threshold value, and the third preset threshold value may be predefined or preconfigured.

For example, if M/N is greater than or equal to 0.75, or K/M is greater than 0.77, the threshold is N/2; if K/M is greater than 0.6 and is less than or equal to 0.77, the threshold is floor(127N/256); if K/M is less than or equal to 0.6, the threshold is floor(63N/128), where floor(N127/256) represents taking a largest integer less than or equal to 127N/256, floor(63N/128) represents taking a largest integer less than or equal to 63/128N. In this example, the first preset threshold value is 0.75, the second preset threshold value is 0.77, the third preset threshold value is 0.6, the first value is N/2, the second value is floor(127N/256), and the third value is floor(63N/128).

For example, when the rate matching manner corresponding to the bit sequence to be transmitted is puncturing, a parameter set is determined based on the length N of the first reliability sequence and the length K of the information bit; and the threshold is determined based on the parameter set, the length N of the first reliability sequence, and the length M of the bit sequence to be transmitted. Optionally, the parameter set includes one or more parameters. Optionally, a value of the parameter included in the parameter set is within [0, 1].

For example, if K/N is less than 0.17, for parameters included in the parameter set Z, z₀=0.77, z₁=0.65, z₂=0.65, and z₃=0.5625; if K/N is greater than or equal to 0.17, for the parameters included in the parameter set Z, z₀=0.9, z₁=0.77, z₂=0.68, and z₃=0.5625. In this example, the parameter set includes four parameters.

For example, if M/N is greater than or equal to a first parameter, and the first parameter is a parameter with a largest value among the parameters included in the parameter set, the threshold is a fourth value, where the fourth value is associated with the length N of the first reliability sequence; if M/N is less than the first parameter and is greater than or equal to a second parameter, and a value of the second parameter is less than a value of the first parameter, the threshold is a fifth value, where the fifth value is associated with the length N of the first reliability sequence, and the parameter set includes the second parameter; if M/N is less than an (S-1)^{th} parameter and is greater than or equal to an S^{th} parameter, the S^{th} parameter is a parameter with a smallest value among the parameters included in the parameter set, and a value of the S^{th} parameter is less than a value of the (S-1)^{th} parameter, the threshold is an (S+3)^{th} value, where the (S+3)^{th} value is associated with the length N of the first reliability sequence, and S is a positive integer; if M/N is less than the S^{th} parameter, the threshold is an (S+4)^{th} value, where the (S+4)^{th} value is associated with the length N of the first reliability sequence.

For example, if z₀≤M/N, the threshold T=N/2; if zₛ≤M/N<zₛ₋₁, the threshold T=floor(N/2-N/2^{9-s}), where 0<s≤S-1, z₀ may be understood as the parameter (the first parameter) with the largest value among the parameters included in the parameter set, and z_{S-1} may be understood as the parameter (the S^{th} parameter) with the smallest value among the parameters included in the parameter set.

For example, the parameter set includes four parameters, and S is equal to 4. A relationship between M/N, the parameters included in the parameter set Z, and the threshold T may be represented by the following Table 1. The parameter set Z is {z₀, z₁, z₂, z₃}, the first parameter is z₀, the second parameter is z₁, a third parameter is z₂, a fourth parameter is z₃, the fourth value is N/2, the fifth value is floor(127N/256), a sixth value is floor(63N/128), a seventh value is floor(31N/64), and an eighth value is floor(15N/32).

**Table 1**

| M/N | T |
|---|---|
| z₀≤M/N | N/2 |
| z₁≤M/N<z₀ | floor(127/256N) |
| z₂≤M/N<z₁ | floor(63/128N) |
| z₃≤M/N<z₂ | floor(31/64N) |
| M/N<z₃ | floor(15/32N) |

For example, if M/N is greater than a first parameter, and the first parameter is a parameter with a largest value among the parameters included in the parameter set, the threshold is a fourth value, where the fourth value is associated with the length N of the first reliability sequence; if M/N is less than or equal to the first parameter and is greater than a second parameter, and a value of the second parameter is less than a value of the first parameter, the threshold is a fifth value, where the fifth value is associated with the length N of the first reliability sequence, and the parameter set includes the second parameter; if M/N is less than or equal to an (S-1)^{th} parameter and is greater than an S^{th} parameter, the S^{th} parameter is a parameter with a smallest value among the parameters included in the parameter set, and a value of the S^{th} parameter is less than a value of the (S-1)^{th} parameter, the threshold is an (S+3)^{th} value, where the (S+3)^{th} value is associated with the length N of the first reliability sequence, and S is a positive integer; if M/N is less than or equal to the S^{th} parameter, the threshold is an (S+4)^{th} value, where the (S+4)^{th} value is associated with the length N of the first reliability sequence.

It should be noted that a quantity of information bits is the length of the information bit. The information bit may include a cyclic redundancy check (cyclic redundancy check, CRC) bit, or may not include a cyclic redundancy check bit. The quantity of information bits may include a quantity of cyclic redundancy check bits, or may not include a quantity of cyclic redundancy check bits.

Optionally, before the rate matching bit set and the threshold are determined, the mother code length N is determined based on the length M of the bit sequence to be transmitted and the length K of the information bit corresponding to the bit sequence to be transmitted. A specific process is as follows:
(1) determining N0, where N0 is a smallest integer power of 2 that is greater than or equal to M, and for example, if M=252, N0=256, or for another example, if M=5, N0=8;
(2) calculating n1, where if K/M<9/16 and M<(1+1/8)*N0/2, n1=log₂(N0)-1; otherwise, n1=log₂(N0);
(3) calculating n2, where $n 2 = \left⌈log2\left(K/{R}_{min}\right)\right⌉$, Rₘᵢₙ =1/8, and Rₘᵢₙ represents a supported minimum code rate;
(4) calculating n, where n=max{min{n1, n2, nmax}, nmin}, a minimum mother code length is 2nmin, a maximum mother code length is 2nmax, nmin=5, nmax=10 during uplink transmission, and nmax=5 during downlink transmission; and
(5) obtaining the mother code length N based on n, where N=2n.

Optionally, before the rate matching bit set and the threshold are determined, the mother code length N is determined based on the length M of the bit sequence to be transmitted, where the mother code length N is a smallest integer power of 2 that is greater than or equal to M. For example, if M=252, N=256. For another example, if M=5, N=8.

S520: Determine the K information bits based on the first reliability sequence, the rate matching bit set, and the threshold.

In an implementation, a sequence number corresponding to the rate matching bit set is removed from the first reliability sequence, to obtain a second reliability sequence, where a length of the second reliability sequence is less than or equal to M; a first subsequence and a second subsequence are determined based on the second reliability sequence; and the K information bits are determined based on the second reliability sequence, the first subsequence, the second subsequence, and the threshold.

For example, N=16, M=12, and the first reliability sequence S1 is [0 1 2 4 8 3 5 9 6 10 12 7 11 13 14 15]. When the rate matching manner is puncturing, the rate matching bit set Q1 is [0 1 2 3], and the second reliability sequence S2 is [4 8 5 9 6 10 12 7 11 13 14 15]. When the rate matching manner is shortening, the rate matching bit set Q1 is [12 13 14 15], the second reliability sequence S2 is [0 1 2 4 8 3 5 9 6 10 7 11], and a length 12 of the second reliability sequence S2 is equal to M (12).

In another implementation, sequence numbers corresponding to the rate matching bit set and a pre-frozen bit set are removed from the first reliability sequence, to obtain a second reliability sequence, where the pre-frozen bit set is determined based on the length M of the bit sequence to be transmitted and the length N of the first reliability sequence, and a length of the second reliability sequence is less than or equal to M; a first subsequence and a second subsequence are determined based on the second reliability sequence; and the K information bits are determined based on the second reliability sequence, the first subsequence, the second subsequence, and the threshold.

Optionally, before the sequence numbers corresponding to the rate matching bit set and the pre-frozen bit set are removed from the first reliability sequence, to obtain the second reliability sequence, the pre-frozen bit set is determined based on the length M of the bit sequence to be transmitted and the length N of the first reliability sequence. For example, bits corresponding to first ceil((N-M)/Δ)*Δ subchannels of polar encoding are determined as the pre-frozen bit set; or bits corresponding to first max(L, ceil((N-M)/Δ)*Δ) subchannels of polar encoding are determined as the pre-frozen bit set, where ceil () represents rounding up, and Δ and L are associated with the length N of the first reliability sequence. A value of Δ may be N/64, N/32, N/16, N/8, N/4, or the like, and a value of L may be N/4, so that stability of polar code performance can be improved. Values of Δ and L may alternatively be other values associated with the length N of the first reliability sequence. This is not limited in this application.

For example, N=16, M=13, and the first reliability sequence S1 is [0 1 2 4 8 3 5 9 6 10 12 7 11 13 14 15]. When the rate matching manner is puncturing, the rate matching bit set Q1 is [0 1 2], the pre-frozen bit set Q2 is [0 1 2 3], the second reliability sequence S2 obtained by removing sequence numbers corresponding to Q1 and Q2 from the first reliability sequence is [4 8 5 9 6 10 12 7 11 13 14 15], and a length 12 of the second reliability sequence S2 is less than M(13), where the pre-frozen bit set Q2 includes the bits corresponding to the first ceil((N-M)/Δ)*Δ subchannels of polar encoding, and Δ=N/4. When the rate matching manner is shortening, the rate matching bit set Q1 is [13 14 15], and the second reliability sequence S2 obtained by removing sequence numbers corresponding to Q1 from the first reliability sequence is [0 1 2 4 8 3 5 9 6 10 12 7 11]. Alternatively, when the rate matching manner is shortening, the rate matching bit set Q1 is [13 14 15], the pre-frozen bit set Q2 is [8], and the second reliability sequence S2 obtained by removing sequence numbers corresponding to Q1 and Q2 from the first reliability sequence is [0 1 2 4 3 5 9 6 10 12 7 11], where a U-bit sequence corresponding to the second reliability sequence S2 is [8 9 10 12 11], first a % bits of the U-bit sequence may be determined as pre-frozen bits, and a % may be 7% or 10%. For example, if a % is 10%, the 1^{st} bit of the U-bit sequence is determined as the pre-frozen bit. Therefore, the pre-frozen bit set Q2 is [8]. Alternatively, when the rate matching manner is shortening and the threshold is not N/2, the rate matching bit set Q1 is [13 14 15], the pre-frozen bit set Q2 is [8], and the second reliability sequence S2 obtained by removing sequence numbers corresponding to Q1 and Q2 from the first reliability sequence is [0 1 2 4 3 5 9 6 10 12 7 11].

In this optional implementation, the second reliability sequence is obtained by removing the sequence numbers corresponding to the rate matching bit set and the pre-frozen bit set from the first reliability sequence, so that accuracy of determining the information bit can be improved, and therefore transmission performance of polar code encoding is improved.

Optionally, a sequence number of a bit included in the first subsequence is less than N/2, and a sequence number of a bit included in the second subsequence is greater than or equal to N/2, where a smallest sequence number in the first reliability sequence is 0. For example, a reliability sequence corresponding to a sequence number less than N/2 in the second reliability sequence S2 is used as the first subsequence, and a reliability sequence corresponding to a sequence number greater than or equal to N/2 in the second reliability sequence S2 is used as the second subsequence. For example, N=16, and the second reliability sequence S2 is [4 8 5 9 6 10 12 7 11 13 14 15]. In this case, it is determined that the first subsequence is [4 5 6 7], and the second subsequence is [8 9 10 12 11 13 14 15]. For another example, N=16, and the second reliability sequence S2 is [0 1 2 4 3 5 9 6 10 12 7 11]. In this case, it is determined that the first subsequence is [0 1 2 4 3 5 6 7], and the second subsequence is [9 10 12 11]. Optionally, the sequence number of the bit included in the first subsequence is less than or equal to N/2, and the sequence number of the bit included in the second subsequence is greater than N/2, where the smallest sequence number in the first reliability sequence is 1.

Optionally, a reliability sequence corresponding to a sequence number greater than or equal to N/2 in the second reliability sequence is used as the second subsequence, and the first subsequence is determined based on the second subsequence. For example, N=8, the first reliability sequence S1 is [0 1 2 4 3 5 6 7], M=6, the rate matching manner is puncturing, and the second reliability sequence is [2 4 3 5 6 7]. In this case, the second subsequence is [4 5 6 7]. A 3^{rd} sequence number and a 4^{th} sequence number that correspond to the second subsequence may be extracted as the first subsequence, so that the first subsequence is [6 7]. Alternatively, a 1^{st} sequence number and a 2^{nd} sequence number that correspond to the second subsequence may be extracted as the first subsequence, so that the first subsequence is [4 5]. For another example, N=8, the first reliability sequence S1 is [0 1 2 4 3 5 6 7], M=8, and the second reliability sequence is [0 1 2 4 3 5 6 7]. In this case, the second subsequence is [4 5 6 7]. [0 1 2 3] is obtained by subtracting N/2 from each element in the second subsequence and used as the first subsequence. Alternatively, the second subsequence may be directly used as the first subsequence. This is not limited in this application.

Optionally, a reliability sequence corresponding to a sequence number less than N/2 in the second reliability sequence is used as the first subsequence, and the second subsequence is determined based on the first subsequence. For example, N=8, the first reliability sequence S1 is [0 1 2 4 3 5 6 7], M=6, the rate matching manner is shortening, and the second reliability sequence is [0 1 2 4 3 5]. In this case, the first subsequence is [0 1 2 3]. A 1^{st} sequence number and a 2^{nd} sequence number that correspond to the first subsequence may be extracted as the second subsequence, so that the second subsequence is [0 1]. Alternatively, a 3^{rd} sequence number and a 4^{th} sequence number that correspond to the first subsequence may be extracted as the second subsequence, so that the second subsequence is [23]. For another example, N=8, the first reliability sequence S1 is [0 1 2 4 3 5 6 7], M=8, and the second reliability sequence is [0 1 2 4 3 5 6 7]. In this case, the first subsequence is [0 1 2 3]. [4 5 6 7] is obtained by adding N/2 to each element in the first subsequence and used as the second subsequence. Alternatively, the first subsequence may be directly used as the second subsequence. This is not limited in this application.

Optionally, if an i^{th} last sequence number in the second reliability sequence is greater than or equal to the threshold, it is determined that a bit indicated by a j^{th} last sequence number in the second subsequence is the information bit, where i is a positive integer ranging from 1 to K, and j is a positive integer ranging from 1 to K; if an i^{th} last sequence number in the second reliability sequence is less than the threshold, it is determined that a bit indicated by a q^{th} last sequence number in the first subsequence is the information bit, where q is a positive integer ranging from 1 to K.

For example, if a last sequence number in the second reliability sequence is greater than or equal to the threshold, it is determined that a bit indicated by a last sequence number in the second subsequence is a 1^{st} information bit; if a 2^{nd} last sequence number in the second reliability sequence is greater than or equal to the threshold, it is determined that a bit indicated by a 2^{nd} last sequence number in the second subsequence is a 2^{nd} information bit; if a 2^{nd} last sequence number in the second reliability sequence is less than the threshold, it is determined that a bit indicated by a last sequence number in the first subsequence is a 2^{nd} information bit. Comparison and determining operations continue until the K information bits are determined.

For example, if the last sequence number in the second reliability sequence is less than the threshold, it is determined that the bit indicated by the last sequence number in the first subsequence is the 1^{st} information bit; if the 2^{nd} last sequence number in the second reliability sequence is greater than or equal to the threshold, it is determined that the bit indicated by the last sequence number in the second subsequence is the 2^{nd} information bit; if the 2^{nd} last sequence number in the second reliability sequence is less than the threshold, it is determined that a bit indicated by a 2^{nd} last sequence number in the first subsequence is the 2^{nd} information bit. Comparison and determining operations continue until the K information bits are determined.

Optionally, if an i^{th} last sequence number in the second reliability sequence is greater than the threshold, it is determined that a bit indicated by a j^{th} last sequence number in the second subsequence is the information bit, where i is a positive integer ranging from 1 to K, and j is a positive integer ranging from 1 to K; if an i^{th} last sequence number in the second reliability sequence is less than or equal to the threshold, it is determined that a bit indicated by a q^{th} last sequence number in the first subsequence is the information bit, where q is a positive integer ranging from 1 to K.

For example, if a last sequence number in the second reliability sequence is greater than the threshold, it is determined that a bit indicated by a last sequence number in the second subsequence is a 1^{st} information bit; if a 2^{nd} last sequence number in the second reliability sequence is greater than the threshold, it is determined that a bit indicated by a 2^{nd} last sequence number in the second subsequence is a 2^{nd} information bit; if a 2^{nd} last sequence number in the second reliability sequence is less than or equal to the threshold, it is determined that a bit indicated by a last sequence number in the first subsequence is a 2^{nd} information bit. Comparison and determining operations continue until the K information bits are determined.

For example, if the last sequence number in the second reliability sequence is less than or equal to the threshold, it is determined that the bit indicated by the last sequence number in the first subsequence is the 1^{st} information bit; if the 2^{nd} last sequence number in the second reliability sequence is greater than the threshold, it is determined that the bit indicated by the last sequence number in the second subsequence is the 2^{nd} information bit; if the 2^{nd} last sequence number in the second reliability sequence is less than or equal to the threshold, it is determined that a bit indicated by a 2^{nd} last sequence number in the first subsequence is the 2^{nd} information bit. Comparison and determining operations continue until the K information bits are determined.

For example, N=16, M=12, K=4, and the first reliability sequence S1 is [0 1 2 4 8 3 5 9 6 10 12 7 11 13 14 15]. Because M<N, and K/M≤7/16, it is determined that the rate matching manner corresponding to the bit sequence to be transmitted is puncturing. Because K/N is greater than 0.17, with an example in which the parameter set includes four parameters, for the parameters included in the parameter set Z, z₀=0.9, z₁=0.77, z₂=0.68, and z₃=0.5625. Because z₂≤M/N<z₁, the threshold T=floor(63N/128)=7. Because the rate matching manner corresponding to the bit sequence to be transmitted is puncturing, N=16, and M=12, it is determined that the rate matching bit set Q1 is [0 1 2 3]. The second reliability sequence S2 obtained by removing the bits included in the rate matching bit set Q1 from the first reliability sequence S1 is [4 8 5 9 6 10 12 7 11 13 14 15]. It is determined that the first subsequence is [4 5 6 7], and the second subsequence is [8 9 10 12 11 13 14 15]. A process of determining, based on the second reliability sequence, the first subsequence, the second subsequence, and the threshold, four information bits corresponding to the bit sequence to be transmitted is as follows:
(1) if a last sequence number 15 in the second reliability sequence is greater than the threshold 7, determining that the bit 15 indicated by a last sequence number in the second subsequence is a 1^{st} information bit;
(2) if a 2^{nd} last sequence number 14 in the second reliability sequence is greater than the threshold 7, determining that the bit 14 indicated by a 2^{nd} last sequence number in the second subsequence is a 2^{nd} information bit;
(3) if a 3^{rd} last sequence number 13 in the second reliability sequence is greater than the threshold 7, determining that the bit 13 indicated by a 3^{rd} last sequence number in the second subsequence is a 3^{rd} information bit; and
(4) if a 4^{th} last sequence number 11 in the second reliability sequence is greater than the threshold 7, determining that the bit 11 indicated by a 4^{th} last sequence number in the second subsequence is a 4^{th} information bit.

Optionally, the information bits may alternatively be determined starting from the 2^{nd} last sequence number in the second reliability sequence, and the last sequence number is ignored. This is not limited in this application.

Optionally, the quantity of information bits is divided based on the second reliability sequence and the threshold, to obtain K1 and K2, and the information bits are determined based on K1, K2, the first subsequence, and the second subsequence, where K1 and K2 are integers, and K1+K2=K. Specifically, K sequence numbers with high reliability in the second reliability sequence are extracted as a set X, where a quantity of sequence numbers that are less than the threshold in the set X is K1, and a quantity of sequence numbers that are greater than or equal to the threshold in the set X is K2. Further, K1 bits with high reliability that are indicated by sequence numbers in the first subsequence and K2 bits with high reliability that are indicated by sequence numbers in the second subsequence are used as information bits. It may be understood that a result obtained according to this method is similar to that obtained according to the foregoing method, and also falls within the protection scope of this application.

The first reliability sequence and the second reliability sequence are ordered from low reliability to high reliability. Optionally, the first reliability sequence and the second reliability sequence may alternatively be ordered from high reliability to low reliability. Optionally, when the second reliability sequence is ordered from high reliability to low reliability, if an i^{th} sequence number in the second reliability sequence is greater than or equal to the threshold, it is determined that a bit indicated by a j^{th} sequence number in the second subsequence is the information bit, where i is a positive integer ranging from 1 to K, and j is a positive integer ranging from 1 to K; if an i^{th} sequence number in the second reliability sequence is less than the threshold, it is determined that a bit indicated by a q^{th} sequence number in the first subsequence is the information bit, where q is a positive integer ranging from 1 to K.

For example, if a 1^{st} sequence number in the second reliability sequence is greater than or equal to the threshold, it is determined that a bit indicated by a 1^{st} sequence number in the second subsequence is a 1^{st} information bit; if a 2^{nd} sequence number in the second reliability sequence is greater than or equal to the threshold, it is determined that a bit indicated by a 2^{nd} sequence number in the second subsequence is a 2^{nd} information bit; if a 2^{nd} sequence number in the second reliability sequence is less than the threshold, it is determined that a bit indicated by a 1^{st} sequence number in the first subsequence is a 2^{nd} information bit. Such operations continue until the K information bits are determined.

For example, if the 1^{st} sequence number in the second reliability sequence is less than the threshold, it is determined that the bit indicated by the 1^{st} sequence number in the first subsequence is the 1^{st} information bit; if the 2^{nd} sequence number in the second reliability sequence is greater than or equal to the threshold, it is determined that the bit indicated by the 1^{st} sequence number in the second subsequence is the 2^{nd} information bit; if the 2^{nd} bit sequence number in the second reliability sequence is less than the threshold, it is determined that a bit indicated by a 2^{nd} sequence number in the first subsequence is the 2^{nd} information bit. Such operations continue until the K information bits are determined.

S530: Perform polar encoding based on the K information bits to obtain a polar encoding result.

For example, after the K information bits are determined, remaining N-K bits are set as frozen bits; and polar encoding is performed on the information bits and the frozen bits, to obtain a polar encoding result with a length of N.

S540: Perform rate matching based on the polar encoding result to obtain the bit sequence to be transmitted.

For example, when the rate matching manner is puncturing, encoded bits corresponding to first N-M bits in the polar encoding result with the length of N are removed, to obtain a bit sequence to be transmitted with a length of M; when the rate matching manner is shortening, encoded bits corresponding to last N-M bits in the polar encoding result with the length of N are removed, to obtain a bit sequence to be transmitted with a length of M; or when the rate matching manner is repetition, a last encoded bit in the polar encoding result with the length of N is repeated for M-N times, to obtain a bit sequence to be transmitted with a length of M. It should be noted that the manner of determining a threshold provided in embodiments of this application may be used in a polar code encoding process corresponding to the rate matching manner of repetition, or no threshold may be used in the polar code encoding process corresponding to the rate matching manner of repetition. This is not limited herein.

In the technical solutions provided in embodiments of this application, the K information bits corresponding to the bit sequence to be transmitted may be determined based on the determined threshold, the rate matching bit set, and the first reliability sequence. In this encoding process, the threshold is introduced to construct a polar code, so that a limitation on a rate matching manner can be reduced, implementation is simple, and a bad point can be avoided. Therefore, encoding performance can be improved.

Optionally, after obtaining the bit sequence to be transmitted by using the technical solutions provided in this application, a transmit end transmits the bit sequence to be transmitted to a receive end. Correspondingly, the receive end receives the bit sequence to be transmitted from the transmit end, and performs polar decoding on the bit sequence to be transmitted. The transmit end may be a terminal device, and the receive end may be a network device. Alternatively, the transmit end may be a network device, and the receive end may be a terminal device.

The foregoing describes the polar code encoding method provided in embodiments of this application. The following describes execution bodies for performing the polar code encoding method.

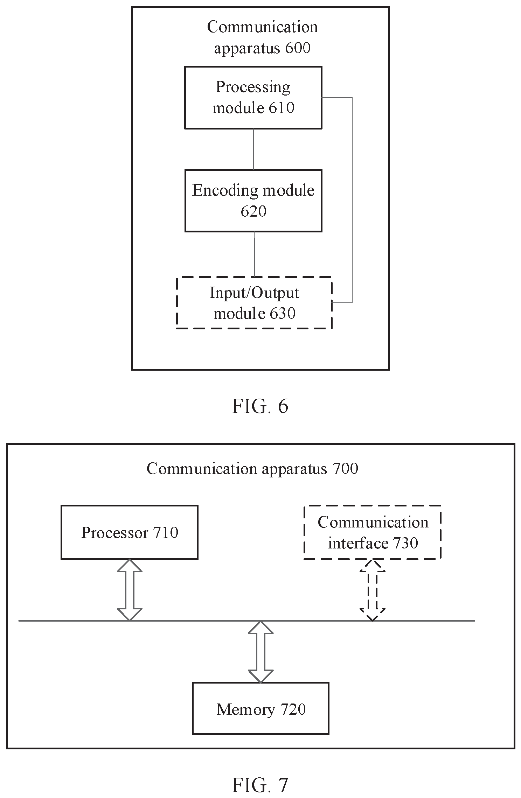

FIG. 6 is a block diagram of a communication apparatus 600 according to an embodiment of this application. The apparatus may be used or deployed in the terminal device or the network device in the method embodiment of this application. The communication apparatus 600 includes:
a processing module 610, configured to determine, based on a length N of a first reliability sequence, a length M of a bit sequence to be transmitted, and a length K of an information bit corresponding to the bit sequence to be transmitted, a rate matching bit set and a threshold that correspond to the bit sequence to be transmitted, where M is a positive integer, N is a positive integer power of 2, and K is a positive integer less than M, where
the processing module 610 is further configured to determine the K information bits based on the first reliability sequence, the rate matching bit set, and the threshold; and
an encoding module 620, configured to perform polar encoding based on the K information bits to obtain a polar encoding result, where
the encoding module 620 is further configured to perform rate matching based on the polar encoding result to obtain the bit sequence to be transmitted.

Optionally, the communication apparatus 600 further includes an input/output module 630, configured to: obtain to-be-encoded information, and output the bit sequence to be transmitted.

Optionally, the processing module 610 is specifically configured to: determine, based on the length M of the bit sequence to be transmitted and the length K of the information bit, a rate matching manner corresponding to the bit sequence to be transmitted; determine the rate matching bit set based on the rate matching manner, the length N of the first reliability sequence, and the length M of the bit sequence to be transmitted; and determine the threshold based on the rate matching manner, the length N of the first reliability sequence, the length M of the bit sequence to be transmitted, and the length K of the information bit.

Optionally, if M/N is greater than or equal to a first preset threshold value, or K/M is greater than a second preset threshold value, the threshold is a first value, where the first value is associated with the length N of the first reliability sequence; if K/M is greater than a third preset threshold value and is less than or equal to the second preset threshold value, the threshold is a second value, where the second value is associated with the length N of the first reliability sequence; if K/M is less than or equal to the third preset threshold value, the threshold is a third value, where the third value is associated with the length N of the first reliability sequence, and the rate matching manner corresponding to the bit sequence to be transmitted is shortening.

Optionally, the processing module 610 is specifically configured to: determine a parameter set based on the length N of the first reliability sequence and the length K of the information bit; and determine the threshold based on the parameter set, the length N of the first reliability sequence, and the length M of the bit sequence to be transmitted, where the rate matching manner corresponding to the bit sequence to be transmitted is puncturing.

Optionally, if M/N is greater than or equal to a first parameter, and the first parameter is a parameter with a largest value among parameters included in the parameter set, the threshold is a fourth value, where the fourth value is associated with the length N of the first reliability sequence;
if M/N is less than the first parameter and is greater than or equal to a second parameter, and a value of the second parameter is less than a value of the first parameter, the threshold is a fifth value, where the fifth value is associated with the length N of the first reliability sequence, and the parameter set includes the second parameter;
if M/N is less than an (S-1)^{th} parameter and is greater than or equal to an S^{th} parameter, the S^{th} parameter is a parameter with a smallest value among the parameters included in the parameter set, and a value of the S^{th} parameter is less than a value of the (S-1)^{th} parameter, the threshold is an (S+3)^{th} value, where the (S+3)^{th} value is associated with the length N of the first reliability sequence, and S is a positive integer; and
if M/N is less than the S^{th} parameter, the threshold is an (S+4)^{th} value, where the (S+4)^{th} value is associated with the length N of the first reliability sequence.

Optionally, the processing module 610 is specifically configured to: remove a bit included in the rate matching bit set from the first reliability sequence, to obtain a second reliability sequence, where a length of the second reliability sequence is less than or equal to M; determine a first subsequence and a second subsequence based on the second reliability sequence; and determine the K information bits based on the second reliability sequence, the first subsequence, the second subsequence, and the threshold.

Optionally, the processing module 610 is specifically configured to: remove sequence numbers corresponding to the rate matching bit set and a pre-frozen bit set from the first reliability sequence, to obtain the second reliability sequence, where the pre-frozen bit set is determined based on the length M of the bit sequence to be transmitted and the length N of the first reliability sequence.

Optionally, the processing module 610 is further configured to determine the pre-frozen bit set based on the length M of the bit sequence to be transmitted and the length N of the first reliability sequence.

Optionally, the processing module 610 is specifically configured to: determine bits corresponding to first ceil((N-M)/Δ)*Δ subchannels of the polar encoding as the pre-frozen bit set; or determine bits corresponding to first max(L, ceil((N-M)/Δ)*Δ) subchannels of the polar encoding as the pre-frozen bit set, where ceil() represents rounding up, and Δ and L are associated with the length N of the first reliability sequence.

Optionally, a sequence number of a bit included in the first subsequence is less than N/2, and a sequence number of a bit included in the second subsequence is greater than or equal to N/2.

Optionally, the processing module 610 is specifically configured to:
if an i^{th} last sequence number in the second reliability sequence is greater than or equal to the threshold, determine that a bit indicated by a j^{th} last sequence number in the second subsequence is the information bit, where i is a positive integer ranging from 1 to K, and j is a positive integer ranging from 1 to K; or
if an i^{th} last sequence number in the second reliability sequence is less than the threshold, determine that a bit indicated by a q^{th} last sequence number in the first subsequence is the information bit, where q is a positive integer ranging from 1 to K.

Optionally, the processing module 610 is specifically configured to:
if a last sequence number in the second reliability sequence is greater than or equal to the threshold, determine that a bit indicated by a last sequence number in the second subsequence is a 1^{st} information bit; and
if a 2^{nd} last sequence number in the second reliability sequence is greater than or equal to the threshold, determine that a bit indicated by a 2^{nd} last sequence number in the second subsequence is a 2^{nd} information bit; or
if a 2^{nd} last sequence number in the second reliability sequence is less than the threshold, determine that a bit indicated by a last sequence number in the first subsequence is a 2^{nd} information bit.

Optionally, the processing module 610 is specifically configured to:
if the last sequence number in the second reliability sequence is less than the threshold, determine that the bit indicated by the last sequence number in the first subsequence is the 1^{st} information bit; and
if the 2^{nd} last sequence number in the second reliability sequence is greater than or equal to the threshold, determine that the bit indicated by the last sequence number in the second subsequence is the 2^{nd} information bit; or
if the 2^{nd} last sequence number in the second reliability sequence is less than the threshold, determine that a bit indicated by a 2^{nd} last sequence number in the first subsequence is the 2^{nd} information bit.

Optionally, the rate matching manner corresponding to the bit sequence to be transmitted includes puncturing or shortening.

Optionally, when the rate matching manner corresponding to the bit sequence to be transmitted is puncturing, the rate matching bit set includes first N-M bits in the first reliability sequence; and when the rate matching manner corresponding to the bit sequence to be transmitted is shortening, the rate matching bit set includes last N-M bits in the first reliability sequence.

FIG. 7 is a block diagram of another communication apparatus 700 according to an embodiment of this application. The communication apparatus 700 includes a processor 710, a memory 720, and a communication interface 730.

The memory 720 is configured to store a computer program.

The processor 710 is coupled to the memory 720 through the communication interface 730. The processor 710 is configured to invoke and run a part or all of the computer program stored in the memory 720, to implement the method in embodiments of this application. The communication apparatus may be used in a first device or a second device in embodiments of this application. Optionally, the processor 710 and the memory 720 are integrated together.

The processor 710 may be an integrated circuit chip, and has a signal processing capability. In an implementation process, the steps in the method embodiment may be completed by using a hardware integrated logic circuit in the processor or by using instructions in a form of software. The processor may be a general-purpose processor, a digital signal processor (digital signal processor, DSP), an ASIC, an FPGA or another programmable logic device, a discrete gate or a transistor logic device, or a discrete hardware component. The processor may implement or perform the method, steps, and logical block diagrams that are disclosed in embodiments of this application. The general-purpose processor may be a microprocessor, or the processor may be any conventional processor or the like. The steps of the method disclosed with reference to embodiments of this application may be directly performed and completed by a hardware decoding processor, or may be performed and completed by using a combination of hardware in the decoding processor and a software module. The software module may be located in a mature storage medium in the art, for example, a random access memory, a flash memory, a read-only memory, a programmable read-only memory, an electrically erasable programmable memory, or a register. The storage medium is located in a memory, and the processor reads information in the memory and completes the steps of the method in combination with hardware of the processor.

Optionally, an embodiment of this application further provides a communication apparatus. The communication apparatus includes an input/output interface and a logic circuit. The input/output interface is configured to obtain input information and/or output information. The logic circuit is configured to perform the method according to any one of the foregoing method embodiments, and perform processing and/or generate the output information based on the input information.

An embodiment of this application further provides a computer-readable storage medium. The computer-readable storage medium stores a computer program for implementing the method in the method embodiment. When the computer program is run on a computer, the method in the method embodiment is implemented.

An embodiment of this application further provides a computer program product. The computer program product includes a computer program. When the computer program is run on a computer, the method in the method embodiment is implemented.

An embodiment of this application further provides a chip, including a processor. The processor is connected to a memory. The memory is configured to store a computer program. The processor is configured to execute the computer program stored in the memory, to enable the chip to perform the method in the method embodiment.

It should be understood that, in embodiments of this application, numbers "first", "second", and the like are merely used to distinguish between different objects, for example, distinguish between different subsequences or values, and constitute no limitation on the scope of embodiments of this application. Embodiments of this application are not limited thereto.

A person of ordinary skill in the art may be aware that, in combination with the examples described in embodiments disclosed in this specification, units and algorithm steps can be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of this application.

It may be clearly understood by a person skilled in the art that, for the purpose of convenient and brief description, for a detailed working process of the described system, apparatus, and unit, refer to a corresponding process in the method embodiment. Details are not described herein again.

In several embodiments provided in this application, it should be understood that the disclosed system, apparatuses, and method may be implemented in other manners. For example, the described apparatus embodiments are merely examples. For example, division into the units is merely logical function division and may be other division during actual implementation. For example, a plurality of units or components may be combined or integrated into another system, or some features may be ignored or not performed. In addition, the displayed or discussed mutual couplings or direct couplings or communication connections may be implemented through some interfaces. The indirect couplings or communication connections between the apparatuses or units may be implemented in electrical, mechanical, or other forms.

The units described as separate parts may or may not be physically separate, and parts displayed as units may or may not be physical units, that is, may be located at one position, or may be distributed on a plurality of network units. Some or all of the units may be selected based on actual requirements to achieve the objectives of the solutions of embodiments.

In addition, functional units in embodiments of this application may be integrated into one processing unit, each of the units may exist alone physically, or two or more units may be integrated into one unit.

When the functions are implemented in a form of a software functional unit and sold or used as an independent product, the functions may be stored in a computer-readable storage medium. Based on such an understanding, the technical solutions of this application essentially, or the part contributing to the conventional technology, or some of the technical solutions may be implemented in a form of a software product. The computer software product is stored in a storage medium, and includes several instructions for instructing a computer device (which may be a personal computer, a server, a network device, or the like) to perform all or some of the steps of the method described in embodiments of this application. The foregoing storage medium includes any medium that can store program code, such as a USB flash drive, a removable hard disk, a read-only memory (read-only memory, ROM), a random access memory (random access memory, RAM), a magnetic disk, or an optical disc.

## Claims

1. A polar code encoding method, comprising:
determining, based on a length N of a first reliability sequence, a length M of a bit sequence to be transmitted, and a length K of an information bit corresponding to the bit sequence to be transmitted, a rate matching bit set and a threshold that correspond to the bit sequence to be transmitted, wherein M is a positive integer, N is a positive integer power of 2, and K is a positive integer less than M;
determining the K information bits based on the first reliability sequence, the rate matching bit set, and the threshold;
performing polar encoding based on the K information bits to obtain a polar encoding result; and
performing rate matching based on the polar encoding result to obtain the bit sequence to be transmitted.

2. The method according to claim 1, wherein determining, based on the length N of the first reliability sequence, the length M of the bit sequence to be transmitted, and the length K of the information bit corresponding to the bit sequence to be transmitted, the rate matching bit set and the threshold that correspond to the bit sequence to be transmitted comprises:
determining, based on the length M of the bit sequence to be transmitted and the length K of the information bit, a rate matching manner corresponding to the bit sequence to be transmitted;
determining the rate matching bit set based on the rate matching manner, the length N of the first reliability sequence, and the length M of the bit sequence to be transmitted; and
determining the threshold based on the rate matching manner, the length N of the first reliability sequence, the length M of the bit sequence to be transmitted, and the length K of the information bit.

3. The method according to claim 1 or 2, wherein
if M/N is greater than or equal to a first preset threshold value, or K/M is greater than a second preset threshold value, the threshold is a first value, wherein the first value is associated with the length N of the first reliability sequence;
if K/M is greater than a third preset threshold value and is less than or equal to the second preset threshold value, the threshold is a second value, wherein the second value is associated with the length N of the first reliability sequence; and
if K/M is less than or equal to the third preset threshold value, the threshold is a third value, wherein the third value is associated with the length N of the first reliability sequence, and the rate matching manner corresponding to the bit sequence to be transmitted is shortening.

4. The method according to claim 1 or 2, wherein determining the threshold based on the length N of the first reliability sequence, the length M of the bit sequence to be transmitted, and the length K of the information bit corresponding to the bit sequence to be transmitted comprises:
determining a parameter set based on the length N of the first reliability sequence and the length K of the information bit; and
determining the threshold based on the parameter set, the length N of the first reliability sequence, and the length M of the bit sequence to be transmitted, wherein the rate matching manner corresponding to the bit sequence to be transmitted is puncturing.

5. The method according to claim 4, wherein
if M/N is greater than or equal to a first parameter, and the first parameter is a parameter with a largest value among parameters comprised in the parameter set, the threshold is a fourth value, wherein the fourth value is associated with the length N of the first reliability sequence;
if M/N is less than the first parameter and is greater than or equal to a second parameter, and a value of the second parameter is less than a value of the first parameter, the threshold is a fifth value, wherein the fifth value is associated with the length N of the first reliability sequence, and the parameter set comprises the second parameter;
if M/N is less than an (S-1)^{th} parameter and is greater than or equal to an S^{th} parameter, the S^{th} parameter is a parameter with a smallest value among the parameters comprised in the parameter set, and a value of the S^{th} parameter is less than a value of the (S-1)^{th} parameter, the threshold is an (S+3)^{th} value, wherein the (S+3)^{th} value is associated with the length N of the first reliability sequence, and S is a positive integer; and
if M/N is less than the S^{th} parameter, the threshold is an (S+4)^{th} value, wherein the (S+4)^{th} value is associated with the length N of the first reliability sequence.

6. The method according to any one of claims 1 to 5, wherein determining, based on the first reliability sequence, the rate matching bit set, and the threshold, the K information bits corresponding to the bit sequence to be transmitted comprises:
removing a bit comprised in the rate matching bit set from the first reliability sequence, to obtain a second reliability sequence, wherein a length of the second reliability sequence is less than or equal to M;
determining a first subsequence and a second subsequence based on the second reliability sequence; and
determining the K information bits based on the second reliability sequence, the first subsequence, the second subsequence, and the threshold.

7. The method according to claim 6, wherein removing the bit comprised in the rate matching bit set from the first reliability sequence, to obtain the second reliability sequence comprises:
removing sequence numbers corresponding to the rate matching bit set and a pre-frozen bit set from the first reliability sequence, to obtain the second reliability sequence, wherein the pre-frozen bit set is determined based on the length M of the bit sequence to be transmitted and the length N of the first reliability sequence.

8. The method according to claim 7, wherein the method further comprises:
determining the pre-frozen bit set based on the length M of the bit sequence to be transmitted and the length N of the first reliability sequence.

9. The method according to claim 8, wherein determining the pre-frozen bit set based on the length M of the bit sequence to be transmitted and the length N of the first reliability sequence comprises:
determining bits corresponding to first ceil((N-M)/Δ)*Δ subchannels of the polar encoding as the pre-frozen bit set; or
determining bits corresponding to first max(L, ceil((N-M)/Δ)*Δ) subchannels of the polar encoding as the pre-frozen bit set, wherein ceil() represents rounding up, and Δ and L are associated with the length N of the first reliability sequence.

10. The method according to any one of claims 6 to 9, wherein
a sequence number of a bit comprised in the first subsequence is less than N/2, and a sequence number of a bit comprised in the second subsequence is greater than or equal to N/2.

11. The method according to any one of claims 6 to 10, wherein determining the K information bits based on the second reliability sequence, the first subsequence, the second subsequence, and the threshold comprises:
if an i^{th} last sequence number in the second reliability sequence is greater than or equal to the threshold, determining that a bit indicated by a j^{th} last sequence number in the second subsequence is the information bit, wherein i is a positive integer ranging from 1 to K, and j is a positive integer ranging from 1 to K; or
if an i^{th} last sequence number in the second reliability sequence is less than the threshold, determining that a bit indicated by a q^{th} last sequence number in the first subsequence is the information bit, wherein q is a positive integer ranging from 1 to K.

12. The method according to claim 11, wherein determining the K information bits based on the second reliability sequence, the first subsequence, the second subsequence, and the threshold comprises:
if a last sequence number in the second reliability sequence is greater than or equal to the threshold, determining that a bit indicated by a last sequence number in the second subsequence is a 1^{st} information bit; and
if a 2^{nd} last sequence number in the second reliability sequence is greater than or equal to the threshold, determining that a bit indicated by a 2^{nd} last sequence number in the second subsequence is a 2^{nd} information bit; or
if a 2^{nd} last sequence number in the second reliability sequence is less than the threshold, determining that a bit indicated by a last sequence number in the first subsequence is the 2^{nd} information bit.

13. The method according to claim 11 or 12, wherein determining the K information bits based on the second reliability sequence, the first subsequence, the second subsequence, and the threshold comprises:
if the last sequence number in the second reliability sequence is less than the threshold, determining that the bit indicated by the last sequence number in the first subsequence is the 1^{st} information bit; and
if the 2^{nd} last sequence number in the second reliability sequence is greater than or equal to the threshold, determining that the bit indicated by the last sequence number in the second subsequence is the 2^{nd} information bit; or
if the 2^{nd} last sequence number in the second reliability sequence is less than the threshold, determining that a bit indicated by a 2^{nd} last sequence number in the first subsequence is the 2^{nd} information bit.

14. The method according to any one of claims 1 to 13, wherein the rate matching manner corresponding to the bit sequence to be transmitted comprises puncturing or shortening.

15. The method according to any one of claims 1 to 14, wherein
when the rate matching manner corresponding to the bit sequence to be transmitted is puncturing, the rate matching bit set comprises first N-M bits in the first reliability sequence; and
when the rate matching manner corresponding to the bit sequence to be transmitted is shortening, the rate matching bit set comprises last N-M bits in the first reliability sequence.

16. A communication apparatus, comprising:
a processing module, configured to determine, based on a length N of a first reliability sequence, a length M of a bit sequence to be transmitted, and a length K of an information bit corresponding to the bit sequence to be transmitted, a rate matching bit set and a threshold that correspond to the bit sequence to be transmitted, wherein M is a positive integer, N is a positive integer power of 2, and K is a positive integer less than M, wherein
the processing module is further configured to determine the K information bits based on the first reliability sequence, the rate matching bit set, and the threshold; and
an encoding module, configured to perform polar encoding based on the K information bits to obtain a polar encoding result, wherein
the encoding module is further configured to perform rate matching based on the polar encoding result to obtain the bit sequence to be transmitted.

17. The apparatus according to claim 16, wherein the processing module is specifically configured to:
determine, based on the length M of the bit sequence to be transmitted and the length K of the information bit, a rate matching manner corresponding to the bit sequence to be transmitted;
determine the rate matching bit set based on the rate matching manner, the length N of the first reliability sequence, and the length M of the bit sequence to be transmitted; and
determine the threshold based on the rate matching manner, the length N of the first reliability sequence, the length M of the bit sequence to be transmitted, and the length K of the information bit.

18. The apparatus according to claim 16 or 17, wherein
if M/N is greater than or equal to a first preset threshold value, or K/M is greater than a second preset threshold value, the threshold is a first value, wherein the first value is associated with the length N of the first reliability sequence;
if K/M is greater than a third preset threshold value and is less than or equal to the second preset threshold value, the threshold is a second value, wherein the second value is associated with the length N of the first reliability sequence; and
if K/M is less than or equal to the third preset threshold value, the threshold is a third value, wherein the third value is associated with the length N of the first reliability sequence, and the rate matching manner corresponding to the bit sequence to be transmitted is shortening.

19. The apparatus according to claim 16 or 17, wherein the processing module is specifically configured to:
determine a parameter set based on the length N of the first reliability sequence and the length K of the information bit; and
determine the threshold based on the parameter set, the length N of the first reliability sequence, and the length M of the bit sequence to be transmitted, wherein the rate matching manner corresponding to the bit sequence to be transmitted is puncturing.

20. The apparatus according to claim 19, wherein
if M/N is greater than or equal to a first parameter, and the first parameter is a parameter with a largest value among parameters comprised in the parameter set, the threshold is a fourth value, wherein the fourth value is associated with the length N of the first reliability sequence;
if M/N is less than the first parameter and is greater than or equal to a second parameter, and a value of the second parameter is less than a value of the first parameter, the threshold is a fifth value, wherein the fifth value is associated with the length N of the first reliability sequence, and the parameter set comprises the second parameter;
if M/N is less than an (S-1)^{th} parameter and is greater than or equal to an S^{th} parameter, the S^{th} parameter is a parameter with a smallest value among the parameters comprised in the parameter set, and a value of the S^{th} parameter is less than a value of the (S-1)^{th} parameter, the threshold is an (S+3)^{th} value, wherein the (S+3)^{th} value is associated with the length N of the first reliability sequence, and S is a positive integer; and
if M/N is less than the S^{th} parameter, the threshold is an (S+4)^{th} value, wherein the (S+4)^{th} value is associated with the length N of the first reliability sequence.

21. The apparatus according to any one of claims 16 to 20, wherein the processing module is specifically configured to:
remove a bit comprised in the rate matching bit set from the first reliability sequence, to obtain a second reliability sequence, wherein a length of the second reliability sequence is less than or equal to M;
determine a first subsequence and a second subsequence based on the second reliability sequence; and
determine the K information bits based on the second reliability sequence, the first subsequence, the second subsequence, and the threshold.

22. The apparatus according to claim 21, wherein the processing module is specifically configured to:
remove sequence numbers corresponding to the rate matching bit set and a pre-frozen bit set from the first reliability sequence, to obtain the second reliability sequence, wherein the pre-frozen bit set is determined based on the length M of the bit sequence to be transmitted and the length N of the first reliability sequence.

23. The apparatus according to claim 22, wherein
the processing module is further configured to determine the pre-frozen bit set based on the length M of the bit sequence to be transmitted and the length N of the first reliability sequence.

24. The apparatus according to claim 23, wherein the processing module is specifically configured to:
determine bits corresponding to first ceil((N-M)/Δ)*Δ subchannels of the polar encoding as the pre-frozen bit set; or
determine bits corresponding to first max(L, ceil((N-M)/Δ)*Δ) subchannels of the polar encoding as the pre-frozen bit set, wherein ceil() represents rounding up, and Δ and L are associated with the length N of the first reliability sequence.

25. The apparatus according to any one of claims 21 to 24, wherein
a sequence number of a bit comprised in the first subsequence is less than N/2, and a sequence number of a bit comprised in the second subsequence is greater than or equal to N/2.

26. The apparatus according to any one of claims 21 to 25, wherein the processing module is specifically configured to:
if an i^{th} last sequence number in the second reliability sequence is greater than or equal to the threshold, determine that a bit indicated by a j^{th} last sequence number in the second subsequence is the information bit, wherein i is a positive integer ranging from 1 to K, and j is a positive integer ranging from 1 to K; or
if an i^{th} last sequence number in the second reliability sequence is less than the threshold, determine that a bit indicated by a q^{th} last sequence number in the first subsequence is the information bit, wherein q is a positive integer ranging from 1 to K.

27. The apparatus according to claim 26, wherein the processing module is specifically configured to:
if a last sequence number in the second reliability sequence is greater than or equal to the threshold, determine that a bit indicated by a last sequence number in the second subsequence is a 1^{st} information bit; and
if a 2^{nd} last sequence number in the second reliability sequence is greater than or equal to the threshold, determine that a bit indicated by a 2^{nd} last sequence number in the second subsequence is a 2^{nd} information bit; or
if a 2^{nd} last sequence number in the second reliability sequence is less than the threshold, determine that a bit indicated by a last sequence number in the first subsequence is the 2^{nd} information bit.

28. The apparatus according to claim 26 or 27, wherein the processing module is specifically configured to:
if the last sequence number in the second reliability sequence is less than the threshold, determine that the bit indicated by the last sequence number in the first subsequence is the 1^{st} information bit; and
if the 2^{nd} last sequence number in the second reliability sequence is greater than or equal to the threshold, determine that the bit indicated by the last sequence number in the second subsequence is the 2^{nd} information bit; or
if the 2^{nd} last sequence number in the second reliability sequence is less than the threshold, determine that a bit indicated by a 2^{nd} last sequence number in the first subsequence is the 2^{nd} information bit.

29. The apparatus according to any one of claims 16 to 28, wherein the rate matching manner corresponding to the bit sequence to be transmitted comprises puncturing or shortening.

30. The apparatus according to any one of claims 16 to 29, wherein
when the rate matching manner corresponding to the bit sequence to be transmitted is puncturing, the rate matching bit set comprises first N-M bits in the first reliability sequence; and
when the rate matching manner corresponding to the bit sequence to be transmitted is shortening, the rate matching bit set comprises last N-M bits in the first reliability sequence.

31. A communication apparatus, comprising a processor and a memory, wherein the memory is configured to store a computer program; and the processor is configured to execute a part or all of the computer program stored in the memory, to perform the method according to any one of claims 1 to 15.

32. A communication apparatus, comprising an input/output interface and a logic circuit, wherein
the input/output interface is configured to obtain input information and/or output information; and
the logic circuit is configured to: perform the method according to any one of claims 1 to 15, and perform processing and/or generate the output information based on the input information.

33. A computer-readable storage medium, wherein
the computer-readable medium stores a computer program; and
when the computer program is run on a computer, the method according to any one of claims 1 to 15 is performed.

34. A computer program product, comprising a computer program, wherein when the computer program is executed, the method according to any one of claims 1 to 15 is implemented.
